# EUROPEAN PATENT APPLICATION

(11) **EP 2 410 565 A1**
(43) Date of publication of application: **25.01.2012**
(21) Application number: 10170265.2
(22) Date of filing: 21.07.2010
(51) Int. Cl.: H01L 23/538, G06K 19/077, H01L 23/498, H05K 1/18, H01L 23/66, H01L 23/58

(54) **Component to connection to an antenna**

(71) Applicant: NXP B.V., 5656 AG Eindhoven (NL)
(72) Inventor: Zenz, Christian, Redhill, Surrey RH1 1DL (GB); Weinberger, Martin, Redhill, Surrey RH1 1DL (GB)
(74) Representative: Hardingham, Christopher Mark

(57) **Abstract**

A component has an embedded IC (34) and a conductor pattern (32) on one side which connects to the IC terminals. A set of filled vias (36) outside the area where the integrated circuit is embedded connect between the conductor pattern (32) and contact bumps (38) on the opposite side of the embedded package. This double-sided package enables improved contact between the component and an antenna (for example). In another aspect, the component has an embedded IC (34) in which the embedded package has a conductor pattern on one side which connects to the IC terminals. An insulator layer is provided over the conductor pattern over the region where the integrated circuit is situated, and connection pads of the conductor pattern extend beyond the insulator layer (60). This defines remote connection pads for connection to spaced antenna tracks and avoids the need for an antenna bridge.

## Description

The present invention relates to a component suitable for connection to an antenna.

The invention relates for example to transmitter or receiver circuits, for example as provided in RFID devices.

Typically, a component of this type includes an integrated circuit providing the receive and/or transmit functionality, and an antenna to receive or transmit signals. The antenna is formed on a substrate, which is, for instance, a plastic foil. The antenna usually is connected to the integrated circuit by means of contacts directly between the antenna coil and contact pads of the integrated circuit. Alternatively, the component may include a strap, also called an interposer, which is connected to the integrated circuit and to the antenna. Then, the antenna may be formed on a separate antenna substrate.

The use of a strap/interposer helps to reduce the size of the electronics. The interposer includes conductive leads or pads that are electrically coupled to the contact pads of the integrated circuit for coupling to the antenna. These pads provide a larger effective electrical contact area to the antenna than IC pads which are precisely aligned for direct placement without an interposer. The larger area reduces the accuracy required for placement of the integrated circuit during manufacture, while still providing effective electrical connection.

The larger area of the contact pads also increases the reliability of the connection between strap/interposer and antenna. The larger distance between the contact pads compared to the distance between the bumps of the IC makes the assembly easier as less placement accuracy is needed.

The ever-decreasing size of integrated circuits continues to complicate the manufacture of suitable antenna or strap contacts configured to be contacted with the contacts of the integrated circuits.

There is, however, still a desire to reduce the size of any microcircuits even if this complicates the interconnection between the microcircuit and external components such as an antenna. Microcircuit manufacturing technologies are considerably more expensive than circuit board manufacturing technologies, so it is desirable to miniaturise the microchips even if new circuit board designs are needed to provide the required connections.

Packaging techniques are known which provide a small microcircuit in a package and provide improved (and further apart) external contacts. The package around the semiconductor component thus facilitates its handling and connection. The surface of a package of a semiconductor component has contact parts, typically protrusions, which allow the packaged component to be easily installed on a circuit board. The package also contains internal conductors, through which signals can be routed to the actual microchip, connecting the protruding contact parts outside the package to the contact areas on the surface of the semiconductor component.

However, the packages of components manufactured using conventional technologies take up a considerable amount of space. The miniaturization of electronic devices has led to an attempt to eliminate the packaging of semiconductor components. For this purpose, the so-called flip-chip technology for instance, has been developed, in which a semiconductor component without a package is assembled directly onto the surface of the circuit board.

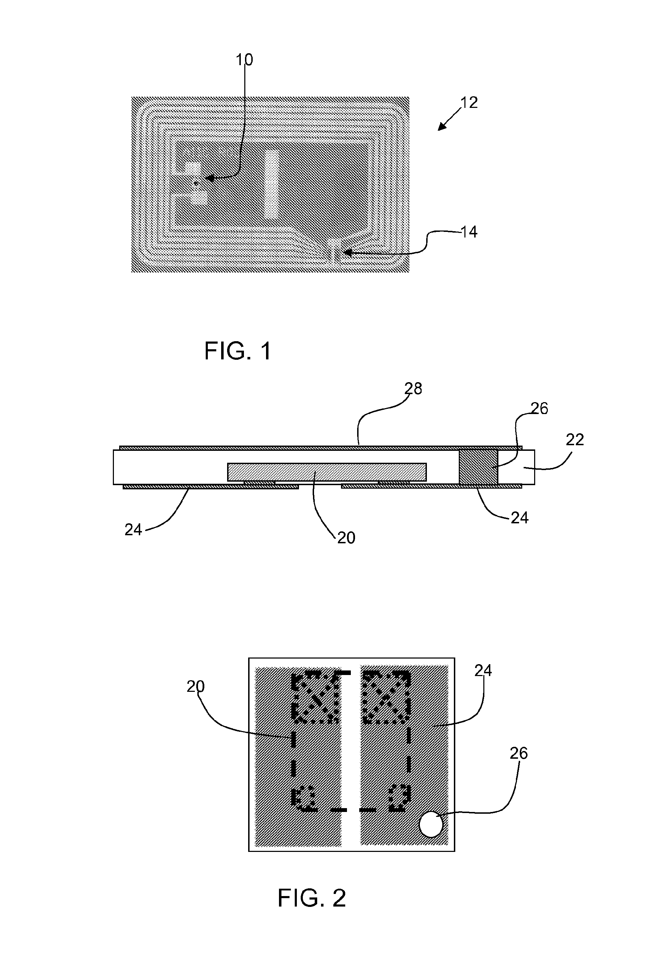

One example of the use of flip chip technology to connect an integrated circuit ("IC") to an antenna is shown in Figure 1. In this example, the IC 10 is too small to provide connection lines that bridge the ends of the antenna coil 12, so it is not provided at the ends of the coil. Instead, the IC is connected in series along one line of the antenna coil. A separate bridge 14 connects the ends of the antenna coil, using a conductor path over an insulator layer. This requires high positional accuracy for the bare IC 10, and also requires additional processing and layers to provide the bridge across the coil ends.

There are, in addition, many difficulties in flip-chip technology. For example, problems can arise with the reliability of connections, especially in applications in which mechanical stresses arise between the circuit board and the semiconductor component. A problem also remains that as the microchips are miniaturised further and further, the connection to the component becomes increasingly difficult. For example, the distance between contact pads (bumps) may be less than 250µm. This increases the cost of making connections between the component and other electric circuit elements, such as the antenna.

The size of an antenna is limited by the electromagnetic performance required, so that the same degree of miniaturisation is not possible. The tolerance levels in the dimensions and positions of the connection points of the antenna are therefore larger, which can make connection to the miniaturised circuit a problem.

A method of providing a microchip which is embedded in a base layer has been presented, for example in US2005/124148. This effectively provides a package, but the microchip is an embedded part of the package (rather than contained within it), so that the size of the package can be more easily selected. This application discloses the embedding of a semiconductor component in a base, such as a circuit board, during the manufacture of the base, whereby part of the base structure is manufactured around the semiconductor component. A surface of the base has contact areas which connect to the microchip.

A problem with this design is that when connecting the base contact areas to an external component (such as an antenna) the pressure applied as part of the connection process can cause damage to the adjacent embedded microchip.

According to the invention, there is provided a component comprising:
a support structure comprising an insulator layer and a conductor pattern on a first side of the insulator;
an integrated circuit embedded in the insulator layer and having contact terminals that make electrical contact with the conductor pattern;
a set of filled vias through the insulator outside the area where the integrated circuit is embedded, that make contact at one end with the conductor pattern; and
a set of contact bumps at the opposite ends of the filled vias, and on the opposite side of the insulator.

The use of both sides of the embedded integrated circuit structure enables the structure to implement a fan-out function to the opposite side of the component. This means that connections to external components are on the opposite side of the structure to the location of the integrated circuit, which means that better contact can be made (a higher pressure can be applied giving deeper imprinting).

The set of vias and contact bumps typically comprises a plurality of vias and contact bumps, but is some examples there may be only one via and one contact bump in the set.

The conductor pattern can comprise regions that connect with test pads of the integrated circuit. This can be used effectively to increase the size of the test pads, so that less precise test probes can be used.

One or more analogue components can also be embedded in the insulator layer and making contact to the conductor pattern. For example, the one or more analogue components can comprise a capacitor. This enables circuits to be formed with capacitances larger than possible only with a highly miniaturised integrated circuit.

The component can further comprise a second set of contact bumps on the first side of the insulator.

The invention also provides a device which comprises a component of the invention and an antenna connected to the set of contact bumps. The contact bumps can be positioned, shaped and sized to match the antenna pattern, so that the precision of the antenna pattern does not need to match the precision of the integrated circuit contact terminals.

According to a second aspect of the invention, there is provided a component comprising:
a support structure comprising a first insulator layer and a conductor pattern on a first side of the first insulator layer;
an integrated circuit embedded in the first insulator layer and having contact terminals that make electrical contact with the conductor pattern;
a second insulator layer over the conductor pattern over the region where the integrated circuit is situated, wherein connection pads of the conductor pattern comprise portions which extend beyond the second insulator layer, such that the conductor pattern has remote connection pads separated by the second insulator layer.

This arrangement provides the combined functions of a bridge (to cross multiple antenna coils) and contact between the IC and the antenna. The insulator layer is part of the component, so it can be directly placed over the antenna pattern using flip chip technology.

The component can be combined with an antenna connected to the connection pads, wherein the antenna comprises a multiple turn spiral antenna pattern, wherein the connection pads connect to the ends of the spiral antenna pattern, with the insulator layer overlying one or more turns of the spiral pattern.

Examples of the invention will now be described in detail with reference to the accompanying drawings, in which:
Figure shows one example of the use of flip chip technology to connect an integrated circuit ("IC") to an antenna;
Figure 2 shows one possible use of an embedded microchip which has been considered (but not published) by the applicant;
Figure 3 shows a first example of component of the invention, in top view, cross sectional view and bottom view;
Figure 4 shows a modification to the design of Figure 3;
Figure 5 shows a further modification in which contact bumps are provided on both sides of the component;
Figure 6 shows another embodiment which does not require through vias; and
Figure 7 is used to show a flip chip process can be used with the component of the invention.

In one aspect, the invention provides a component having an embedded IC in which the embedded package has a conductor pattern on one side which connects to the IC terminals, and a set of filled vias (outside the area where the integrated circuit is embedded), that connect between the conductor pattern and contact bumps on the opposite side of the embedded package. This double-sided package enables improved contact between the component and an antenna (for example). In another aspect, the component has an embedded IC in which the embedded package has a conductor pattern on one side which connects to the IC terminals. An insulator layer is provided over the conductor pattern over the region where the integrated circuit is situated, and connection pads of the conductor pattern extend beyond the insulator layer. This defines remote connection pads for connection to spaced antenna tracks and avoiding the need for an antenna bridge.

Figure 2 shows one possible use of an embedded microchip which has been considered (but not published) by the applicant.

The microchip 20 is embedded in a circuit board 22. Connection pads 24 are provided on the base, for connection to the antenna contacts. A through via 26 connects to a top electrode 28. The manufacturer can choose if they want to connect the component only on one side using both contacts 24, or on the top and bottom using the bottom left contact 24 and the top contact 28.

The embedding process is well known. The microchip is embedded in a PCB laminate, or it may be embedded in thermo lasts (such as polycarbonate, or PETG).

When an IC is directly bonded to an antenna, variation in the pressure, temperature and materials can change the performance of the IC due to the change of the distance between IC and the metal leads of the antenna (for example due to capacitance changes). By embedding the IC, the distance between the IC and the antenna is always the same therefore decreasing the variation of the performance. Also, higher pressures can be applied to the embedded IC compared to the stand alone thin IC.

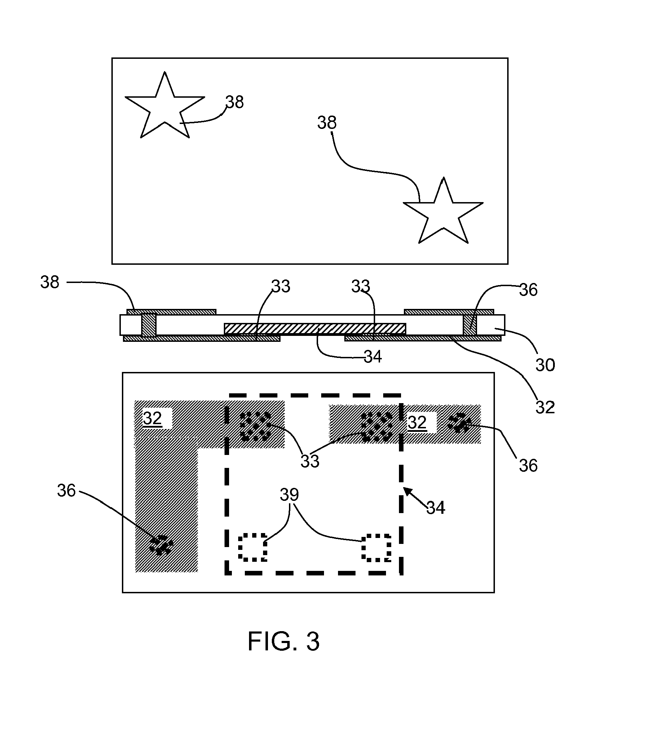

Figure 3 shows a first example of component of the invention, in top view, cross sectional view and bottom view.

The component comprises an embedded integrated circuit having a support structure 30 comprising an insulator layer, and a conductor pattern 32 on a first side of the insulator layer. The integrated circuit 34 is embedded in the insulator layer 30 and makes electrical contact with the conductor pattern 32 at its connection terminals 33. The insulator layer is preferably part of a laminate circuit board structure.

By way of example, the support 30 may be 200µm thick, although thinner supports may be used in the future. Typically, the support may be between 100µm and 300µm thick. The IC 34 may be 75µm thick, again with thickness likely to decrease to 50µm or less in the future. Typically, the IC may be between 30µm and 100µm thick. The IC 34 is generally less than half as thick as the support. The metal contact layers are typically around 20µm thick,

Figure 3 shows that the integrated circuit 34 is not centrally embedded, but nearer the bottom face of the support 30 (i.e. the first side) than the opposite top face. This keeps the length of the contacts between the conductor pattern 32 and the terminals 33 as short as possible.

However, for reliability reasons IC can be placed in the middle of the package.

The conductor pattern 32 extends beyond the outer area of the integrated circuit 34. A set of vias 36 is situated outside the area where the integrated circuit 34 is embedded and the vias each contact at one lower end with the conductor pattern 32. The other, top ends of the vias 36 connect to a second conductor pattern 38 in the form of a set of contact bumps.

The contact bumps can take any size or shape, for example to match the antenna connection pads. Star shapes have been shown by way of random example.

In this example, the integrated circuit also has test pads 39 to which no electrical connection is made.

As shown in the bottom view, the purpose of the pattern 32 is to connect between the IC contact pads 33 and the vias 36 and any suitable shape may be used. The pattern 32 essentially provides a fan-out from the narrow IC contact terminals to more widely spaced contact bumps 38. The IC contact pads may be spaced by 250µm (typically spaced in the range 100µm to 1 mm), whereas the contact bumps will be typically spaced at least twice as far apart, for example in the range 1 mm to 10mm.

The component is attached to the antenna upside down with respect to the design of Figure 2. Thus, the external connections from the package are on the opposite side of the package to the first conductor pattern 32, and therefore on the opposite side with respect to the connection face of the integrated circuit.

Large connection bumps 38 can be provided, and they can be spaced at any required distance by making the support of the embedded integrated circuit of suitable size. The electrical pads of the first conductor pattern 32 can also have large area, in that they can fan out to a large size once the pattern is beyond the integrated circuit boundary.

The contact bumps can be optimised for the required external connection. Typically, a standard PCB manufacturing process is used, which has structured copper plates.

Thus, the bumps can be copper (although optionally with coatings such as gold) for example for connection to copper antenna tracks. Thus, hard connection bumps can be used and with a large thickness.

The bottom and top conductor patterns can be formed by a lamination process, which laminates the copper-insulator-copper plates.

The component can be attached to the antenna using a conventional thermo-compression process, i.e. a flip chip bonding process.

A standard flip chip assembly comprises:
- glue dispensing
- IC attachment
- curing of the glue by thermodes (hot plates on top and the bottom) which apply temperature and pressure at the same time.

If the pressure can be increased, the reliability of the connection is increased as the bumps can be imprinted deeper into the antenna material.

Alternatively, a crimping process can be used, which is common for connecting two aluminium contacts by joining them together, to provide a good reliable connection.

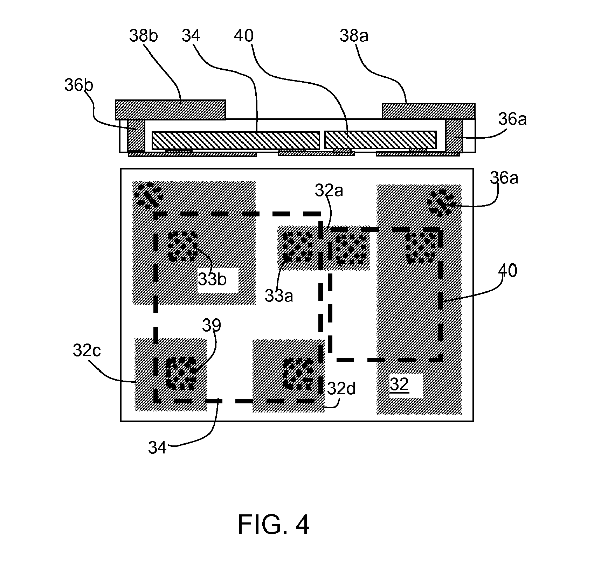

Figure 4 shows a modification to the design of Figure 3, in which the insulator layer 30 also embeds an additional component, for example an analogue component such as a capacitor 40. A portion 32a of the first conductor pattern 32 makes a connection between one of the contact pads 33a of the integrated circuit 34 and one terminal of the capacitor 40, and the other terminal of the capacitor connects through a via 36a to an upper contact bump 38a.

The other contact pad 33b of the integrated circuit makes connection through a via 36b to the contact bump 38b.

The miniaturisation of integrated circuits means the maximum capacitance which can be achieved within the chip is reduced. The arrangement of Figure 4 enables additional external capacitance to be added within the embedded structure.
Figure 4 also shows that the first conductor pattern can include portions 32c, 32d that contact the test pads 39 of the integrated circuit. This means that the package can be tested (before mounting to the antenna) with reduced positioning accuracy for the test probe needles.

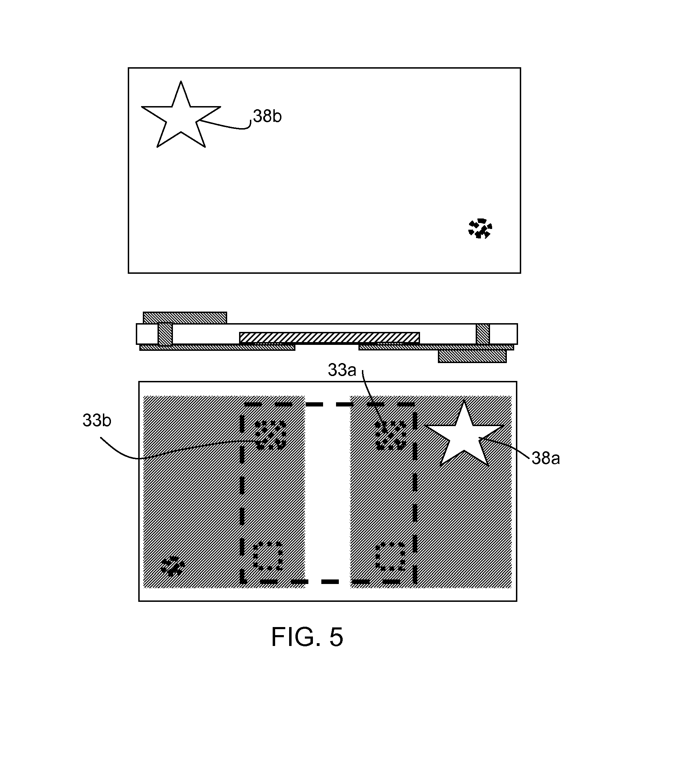

Figure 5 shows a further modification in which contact bumps are provided on both sides of the component.

One terminal 33a of the IC connects to a contact bump 38a on the lower surface, and the other terminal 33b connects to a contact bump 38b on the upper surface. In this case, contact bumps 38a and 38b should be connected to the antenna. This design is suitable for a package which will be manually soldered, as the soldering process is easier.

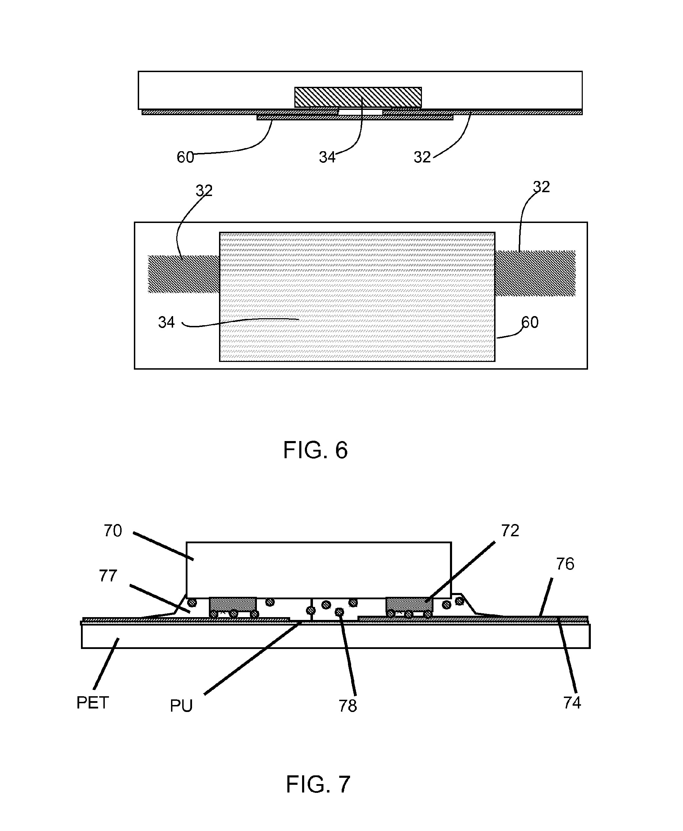

Figure 6 shows another embodiment which does not require through vias. The figure shows a cross section and a view from beneath. The integrated circuit 34 connects to the first conductor pattern 32 as in the examples above. The two areas of the pattern 32 extend a long way to each side of the integrated circuit. A central area, beneath the integrated circuit 34, is covered by a second insulating layer 60 provided on the underside of the embedded integrated circuit.

The insulator layer is thin compared to the other layers of the structure, for example 1µm thick compared to 18-35 µm thickness of the electrode pattern 32.

This arrangement can be used as a bridge at the ends of the antenna coil, but without requiring additional layers on the antenna foil. The insulator 50 covers the central antenna tracks, and the exposed parts of the conductor pattern 32 make contact to a respective end contact of the antenna. This is of particular interest for applications using coil shape antennas, such as high frequency applications.

The invention makes use of an embedded integrated circuit approach, which offers a low cost packaging solution, for example less than 1 US Cent per mm². The layout design is highly flexible, and the embedded package can be attached using existing equipment for direct chip attach, even though the chip size can be progressively reduced. Copper bumps can be used to improve the connection quality for a direct chip attach process. Coatings can also be used, for example a gold coating to improve connection reliability.

As explained above, the package can be bonded using standard flip chip assembly, for example with ACP (anisotropic conductive glue).

The structure resulting from a standard flip chip assembly is shown in Figure 7 for an antenna with aluminium contacts. The package is shown as 70, with gold bumps (or gold coated copper bumps) 72. These are for contacting aluminium antenna tracks 74, having an aluminium oxide surface 76. The ACP 77 has conductive particles 78 which breach the aluminium oxide layer and make the contact.

The antenna substrate is for example PET (Polyethylene terephthalate) with a PU (polyurethane) insulating coating.

The ability to use higher pressures to imprint the contact bumps deep into the metal of the antenna means the conductive particles are no longer required. The bumps of the IC are normally 60x60µm, whereas the contact bumps of the package of the invention can be significantly larger resulting in a larger contact area and therefore giving a better electrical connection. Thus, a non conductive glue can be used instead of the ACP.

Normally the structures underneath the bump of an embedded IC package are only capacitors, as bonding over active areas of the IC is forbidden, since during the assembly, the pressure on the bumps could damage the structures below. The design of the invention avoids any pressure on the bond pads of the IC, which gives more flexibility in the layout, and which can result in a smaller IC.

The component enables the resolution requirements for the antenna to be relaxed.

As will be apparent from the description above, the main application of the invention is for the connection between a component having an IC and an antenna. However, the same principles can be used for the connection of the embedded IC package and any other external component.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A component comprising:
a support structure comprising an insulator layer (30) and a conductor pattern (32) on a first side of the insulator;
an integrated circuit (34) embedded in the insulator layer and having contact terminals (33) that make electrical contact with the conductor pattern (32);
a set of filled vias (36) through the insulator outside the area where the integrated circuit (34) is embedded, that make contact at one end with the conductor pattern (32); and
a set of contact bumps (38) at the opposite ends of the filled vias, and on the opposite side of the insulator (30).

2. A component as claimed in claim 1, wherein the conductor pattern (32) comprises regions that connect with test pads (39) of the integrated circuit (34).

3. A component as claimed in claim 1 or 2, further comprising one or more analogue components (40) also embedded in the insulator layer (30) and making contact to the conductor pattern (32).

4. A component as claimed in claim 3, wherein the one or more analogue components (40) comprise a capacitor.

5. A component as claimed in any preceding claim, further comprising a second set of contact bumps (38a) on the first side of the insulator.

6. An electronic device, comprising a component as claimed in any preceding claim, and an antenna connected to the set of contact bumps.

7. A component comprising:
a support structure comprising a first insulator layer (30) and a conductor pattern (32) on a first side of the first insulator layer (30);
an integrated circuit (34) embedded in the first insulator layer (30) and having contact terminals (33) that make electrical contact with the conductor pattern;
a second insulator layer (60) over the conductor pattern over the region where the integrated circuit (34) is situated, wherein connection pads of the conductor pattern (32) comprise portions which extend beyond the second insulator layer (60), such that the conductor pattern (32) has remote connection pads separated by the second insulator layer (60).

8. An electronic device, comprising a component as claimed in claim 7, and an antenna connected to the connection pads, wherein the antenna comprises a multiple turn spiral antenna pattern, wherein the connection pads connect to the ends of the spiral antenna pattern, with the second insulator layer (60) overlying one or more turns of the spiral pattern.
